# EUROPEAN PATENT SPECIFICATION

(11) **EP 3 562 280 B1**
(45) Date of publication and mention of the grant of the patent: **13.11.2024**
(21) Application number: 18169055.3
(22) Date of filing: 24.04.2018
(51) Int. Cl.: H05K 7/14, H05K 3/36

(54) **PCB CONNECTOR**
PCB-ANSCHLUSS
CONNECTEUR DE CARTE À CIRCUIT IMPRIMÉ

(43) Date of publication of application: 30.10.2019
(60) Divisional application: 24204509.4
(73) Proprietor: Delta Electronics (Thailand) Public Co., Ltd., Samutprakarn 10280 (TH)
(72) Inventor: KÖNIG, Magnus, 79369 Whyl (DE)
(74) Representative: Keller Schneider Patent- und Markenanwälte AG

(56) References cited:
- DE-A1- 102011 056 082
- DE-C1- 3 744 189
- US-A- 4 644 614
- US-A1- 2010 259 907
- US-A1- 2013 164 950

## Description

### Technical Field

The invention relates to a connector for removably connecting a first printed circuit board to a second printed circuit board arranged perpendicular to the first printed circuit board, the connector having a locking portion for inserting through an opening of the first printed circuit board and a head portion for retaining the connector on the first printed circuit board. The invention further relates to a corresponding printed circuit board assembly where a first printed circuit board is connected to a second printed circuit board arranged perpendicular to the first printed circuit board by such a connector and to corresponding methods for connecting and disconnecting two printed circuit boards.

### Background Art

Many or even most electronic devices include at least one printed circuit board (PCB). A PCB usually carries multiple electronic components mounted (usually soldered) on the PCB where the components are electrically connected to each other by conductive tracks, pads and other features etched from copper sheets laminated onto a non-conductive substrate such as for example FR-4 glass epoxy. PCBs may be single sided with one copper layer or double sided with two copper layers. They may also be multilayer PCBs with a single or multiple inner and/or outer layers of copper where the conductors of different layers are connected with so-called vias. Instead of copper, other conductive materials, particularly other metals are also used.

A PCB not only electrically interconnects the components but usually also mechanically supports the components. Although PCBs require additional design effort to lay out the electric circuit, manufacturing is usually cheaper than other methods for wiring multiple components because manufacturing and assembly can be automated.

Different names exist for such PCBs: printed wiring board, etched wiring board, printed circuit assembly, printed circuit board assembly, circuit card assembly, and so on. Other terms again are used for backplanes. While some of these terms are used only for empty PCBs (with no mounted components), others are used only for assembled PCBs (with mounted components) and some terms are used whether components are mounted thereon or not.

In the following, the term printed circuit board or PCB is used as a broad term covering any type of circuit board, backplane or the like, either with or without mounted components, whether electrical, mechanical or other components.

Some electronic devices are rather complex and require more than one PCB. A set of two or more PCBs that belong together and are connected to each other is designated herein as a printed circuit board assembly (PCBA). The PCBs of a PCBA are usually electrically connected to each other by cables, pin-and-socket connectors or the like. At the same time, these electrical connections - particularly in the case of pin-and-socket connections - often also serve as a mechanical connection wherefore the PCBs do usually not include further mechanical connections. If such a PCBA then is exposed to vibration, since it is for example mounted in a vehicle or in another moving or agitating environment, the electrical connections may become loose and the electrical contact may unintentionally get lost. The PCBs may even completely disconnect from each other and fall apart.

US 2013/089992 A1 (Samsung Electronics) describes such a PCBA. It discloses a structure for stacking printed circuit board assemblies. The structure includes a clip mounted on a main printed circuit board (PCB) and a clip header mounted on a sub-PCB. The main PCB and the sub-PCB are arranged in parallel to each other and the clip header of the sub-PCB is inserted into the clip of the main PCB. In this way, the main and the sub-PCB are connected to each other and since the clip and the clip header are made from a metal, they also provide shielding. However, due to vibrations, the clip header may move out of the clip and loose its connection. Furthermore, the structure discloses might not be used to connect two PCBs that are arranged perpendicular to each other.

US 6'470'555 B2 (Micron Technology, Inc.) discloses another device for mounting two planar electrical components. The mounting spacer described is used for mounting a computer motherboard parallel and in a distance to a chassis, for example to a computer chassis. The spacer is made of an electrically conductive material to ensure ground connection of the motherboard to the chassis. It includes a clip at its upper and at its lower part. First, one or more spacers are attached to the chassis by inserting their lower clip, an angled extension of the spacer, into mounting slots thereby clamping the spacer to the chassis. And second, the motherboard is fastened by clipping it onto the upper clips of the spacers. Accordingly, the motherboard is mounted in a distance from the chassis that corresponds substantially to the height of the spacer. However, since the spacer is described to clamp itself onto the chassis, it is made of a material that is capable of a reversible deformation. Accordingly, the lower angled extension may for example slip out of the corresponding slot of the chassis in case of a force applied to the spacer in a direction from the chassis to the motherboard, i.e. more or less perpendicular to the chassis in the direction of the motherboard. Therefore, the connection between the spacer and the chassis may also become loose and the motherboard may completely disconnect from the chassis or at least the ground connection may be lost. A further disadvantage is that the spacer can not be used to connect a motherboard in a perpendicular position to the chassis.

Another known method to connect PCBs is screws. However, at least one particular tool is needed to tighten the screws. Where nuts are to be used together with the screws even a second tool is necessary to hold the nuts while screwing. And in case the PCBs shall be separated again, the one or even two particular tools (or similar ones) are needed again to loosen the screws. Accordingly, not only connecting the PCBs but also their separation is rather laborious and elaborate. And furthermore, in case of vibrations such screws may also become loose and the PCBs might be separated unintentionally. In such a case one might take additional measures to avoid such a loosening, but such measures might in turn make the later separation of the PCBs even more laborious and elaborate.

DE 37 44 189 C1 discloses a connector for removably connecting a first PCB to a second PCB perpendicular to the first PCB. The connector has a plate-shaped base frame on one side of which a locking portion for inserting through an opening of the first PCB is located and on the opposite side of which two holders for holding the second PCB are located. The locking portion is pushed through the hole in the first PCB in order to establish a link between the first PCB and the connector. The second PCB is pushed into a slot formed by the two holders. A locking element located on the first holder engages with a hole in the second PCB in order to establish a positive lock along the direction of the holders. A link located close to the non-free ends of the holders establishes a physical link between the two halves of the connector that are separated by the slot. The holders are located on one side of the base frame and the locking portion is located on the other side. Thereby, the connector obtains a resilience on both sides of the base frame, which is necessary because the locking portion has to be inserted into the hole of the first PCB, and the second PCB has to be inserted between the holders.

US 2010/0259907 A1 shows a connector for removably connecting a PCB to an enclosure arranged perpendicular to the PCB, the connector having a locking portion for inserting through an opening of the enclosure and a head portion for retaining the connector on the enclosure, wherein the locking portion includes a first locking element adapted to interact with a second locking element of the PCB for positive locking the connector and the PCB regarding forces in a direction perpendicular to the enclosure such that the PCB is fixed to the enclosure when the connector is inserted through the opening of the enclosure and the first and the second locking element are positive locked to each other.

### Summary of the invention

It is the object of the invention to create a connector pertaining to the technical field initially mentioned, that enables to mechanically fix two perpendicularly arranged printed circuit boards to each other where the connector may be easily removed to such that the connection between the printed circuit boards is released.

It is another object of the invention to provide a corresponding printed circuit board assembly as well as a corresponding method for connecting a first printed circuit board to a second printed circuit board arranged perpendicular to the first printed circuit board or disconnecting the first printed circuit board from the second printed circuit board.

The invention is set out in the appended set of claims. According to the invention the locking portion includes a first locking element adapted to interact with a second locking element of the second printed circuit board for positive locking the connector and the second printed circuit board regarding forces in a direction perpendicular to the first printed circuit board. Accordingly, when the connector is inserted through the opening of the first printed circuit board and the first and the second locking element are positive locked to each other, the first printed circuit board is fixed to the second printed circuit board, where fixed in this context means mechanically fixed.

So, two PCBs may easily be connected to each other by simply arranging the PCBs properly, inserting the connector with its locking portion through the opening of the first PCB until the head portion of the connector is retained on the first PCB and the first locking element of the first PCB engages with the second locking element of the second PCB thereby fixing the two PCBs to each other. Properly arranging the two PCBs in this connection means that the second PCB is perpendicularly arranged with respect to the first PCB such that an edge of the second PCB is in touch with a surface area of the first PCB. The two PCBs are so to speak forming from a kind of T, where the first PCB corresponds to the horizontal bar and the second PCB corresponds to the vertical bar.

The particular position of the second PCB on the surface of the first PCB is given by design, i. e. by the required relative position of the two PCBs due to the mounted components and the required electrical connections between the PCBs. The position and the form of the opening in the first PCB as well as the position and the form of the second locking element of the second PCB are then provided accordingly.

The term opening of the first PCB as used herein may designate a hole in the first PCB but it may also designate a recess or a cut of a suitable size and form in an edge area of the first PCB. Preferably, the head portion is arranged at an end region of the connector and the locking portion is arranged at another end region of the connector opposite the head portion. Accordingly, the head portion and the locking portion define a longitudinal axis extending through the head portion and the locking portion. And although the connector preferably has an overall elongate shape in the direction of that longitudinal axis the connector may also have another shape with a maximum size in a direction perpendicular to the longitudinal axis of the connector. In this case, the head portion and the locking portion might be arranged at the same end region of the connector or they might be arranged in a certain distance to each other.

The head portion retains the connector on the first PCB when the connector is inserted through the opening in the PCB and the two PCBs are fixed to each other by the connector. So a part of the head portion must fit through the opening while another part of it must not fit through the opening.

The head portion accordingly has a base for fitting through the opening of the first printed circuit board and a retaining section for retaining the connector on the first printed circuit board. The base portion thereby might help guiding the connector through the opening and positioning it within the opening. And the retaining section prohibits that the connector is inserted too far by prohibiting further insertion when it gets in touch with the first PCB, thereby defining a distance between the lower surface of the first PCB and the first locking element. This distance then must correspond to the distance between the edge of the second PCB that is in touch with the first PCB and the second locking element of the second PCB such that the two locking elements might properly interact to positively lock to each other.

In an embodiment not in accordance with the claimed invention, the base portion might also be omitted. However, in this case, the connector might lack a guide for insertion which makes it more difficult to insert the connector. And it might also be more difficult to properly position the connector once inserted into the opening of the first PCB.

In order to reach an optimal guidance and positioning of the connector when inserting it into the opening of the first PCB, the base has a generally cylindrical shape which in this case means a right cylindrical shape. The shape is however not restricted to a circular shape. The shape of the right cylindrical base preferably corresponds to the shape of the opening. So in an embodiment not in accordance with the claimed invention, if the opening in the first PCB is a square, the base preferably also has a square shape that more or less exactly fits into the opening. For openings having for example a triangular or a rectangular shape the base preferably also has a corresponding triangular or rectangular shape respectively.

However, since an opening in a PCB is most easily done by drilling such an opening in most cases will have a circular shape, wherefore in accordance with the claimed invention, the base has a generally cylindrical shape.

The head portion further includes a flange like edge extending at least partially over the base. Accordingly, while the base fits through the opening, the flange like edge does not fit through the opening and therefore retains the connector on the first PCB. The term at least partially in this connection means that the flange does not have to necessarily run along the whole outer edge but that the flange might be interrupted or might even be present at only some portions around the circumference of the base.

The first and the second locking element together form a locking mechanism for positive locking. Positive locking in this connection means positive locking regarding forces in the direction of the longitudinal axis of the connector, which is in a direction perpendicular to the first PCB when the connector is installed to fix a second PCB to the first PCB. The surface of the first PCB with which the second PCB is in contact is designated hereinafter as the down facing surface of the first PCB. Accordingly, the other surface is designated as the up facing surface of the first PCB.

Up and down in this respect therefore designate the two directions perpendicular to the first PCB where down corresponds to the direction facing away from the down facing surface of the first PCB and up corresponds to the direction facing away from the up facing surface of the first PCB. The terms up and down are also used to designate the directions along the longitudinal axis of the connector where down designates the direction from the head portion to the locking portion and up designates the opposite direction. When the connector is properly installed to fix the two PCBs to each other, the up and down directions with respect to the connector are substantially identical to the up and down directions as defined in connection with the first PCB.

One possibility to fix the two PCBs to each other is to adapt the connector such that it can be on the one hand fixed to the first PCB and that it can be fixed on the other hand to the second PCB where both fixations are independent of each other. Such fixations or connections can for example be realised as clips or other known connections with positive or non-positive locking or the like.

However, in a preferred embodiment of the invention, in order to fix the two PCBs to each other the fixation of the connector to the first PCB is not independent of its fixation to the second PCB.

Here, the edge of the second PCB with which it is in contact with the first PCB is clamped to the down facing surface of the first PCB where this clamping is realised by the connector. To achieve such a clamping, the first locking element of the connector includes a locking area arranged to face the flange like edge of the head portion. Accordingly, the locking area faces up whereas the flange like edge faces down such that the locking area and the flange like edge form two clamping members of a clamping mechanism for clamping the two PCBs to each other. Whereas the down facing flange like edge is in contact with the up facing surface of the first PCB, the up facing locking area of the connector interacts with a corresponding down facing locking area of the second PCB. Therefore, at the upper end of the connector, the down facing flange like edge is in contact with the up facing surface of the first PCB and the down facing surface of the first PCB is in contact with the upper edge of the second PCB. At the lower end of the connector, it's up facing locking area is in contact with a down facing locking area of the second PCB. And to achieve clamping, the distance between the down facing flange like edge and the up facing locking area is designed to correspond to (or to be slightly less than) the sum of the thickness of the first PCB and the distances between the upper edge and the down facing locking area of the second PCB.

Or formulated more generally, the first and the second PCB are clamped between the retaining section of the head portion and the up facing locking area of the connector. The locking areas of the connector and the second PCB thereby are preferably designed to match each other to achieve a good contact when clamping the two PCBs to each other.

In one example, the first locking element of the connector includes a recess or opening in the locking portion where the recess or opening has an inner surface area forming the up facing locking area. And the second locking element of the second PCB includes a protrusion or the like having an area of the surface facing down thereby forming the down facing locking area. When the connector is installed, the connectors head portion comes in touch with the up facing surface of the first PCB whereas the up facing locking area of the connector and the down facing locking area of the second PCB become arranged about each other thereby clamping the two PCBs together and preventing relative movements of the connector and the two PCBs in up and down directions. In such a configuration however a protrusion or the like has to be formed on the second PCB which involves some additional steps during manufacturing of the second PCB or during installation.

The locking portion of the connector includes a protrusion or the like having an up facing locking area and the second locking element of the second PCB includes a recess or opening having an inner surface area that forms the down facing locking area. When the connector is installed, the up facing locking area on the protrusion of the connector and the down facing locking area of the recess or opening become arranged about each other thereby clamping the two PCBs together and preventing relative movements of the connector and the two PCBs in up and down directions. In such a configuration no protrusion or the like has to be formed on the second PCB but on the connector. This does however not involve additional steps during manufacturing but the connector as a whole may be formed in a single step for example by injection moulding or the like.

As already mentioned above, the connector includes a locking portion arranged at a lower end of the connector which is to be inserted through the opening in the first PCB and which includes the first locking element which - as described above - might be in the form of a locking area, either as an inner surface area of a recess or opening or the like or as an outer surface area of a protrusion or the like.

The locking portion itself may have any desired or suitable shape. It may be short and wide round or edged or may have any other shape.

According to the claimed invention, the locking portion however includes an elongated body where the first locking element is located at an end region of the elongated body opposite the head portion. Further, the locking element includes a hook-like protrusion for latching into an opening or a recess of the second PCB. This opening or recess within the second PCB is adapted to receive the hook-like member when the connector is in its proper position for connecting the two PCBs.

The elongated body has the effect that the locking portion shows a slight amount of flexibility. It can therefore be bent just a little bit but enough to be slightly pre-stressed during insertion before the hook-like protrusion latches into the opening of the second PCB.

The flexibility of the connector obviously also depends on the material of which it consists. The connector preferably is made of a synthetic material such as plastic or the like. Although there also exist synthetic materials that may conductive, the connector preferably is made of an electrically isolating synthetic material such that no current may flow through the connector from one of the PCBs to the other. But the connector can also be made of an electrically conductive material such as a metal or any other material capable of carrying current such as composite materials. In case of a metal, the connector is for example made of copper, aluminium or the like showing a high electrical conductivity.

The elongated body of the locking portion is preferably arranged at an edge area of the cylindrical base. This means that the elongated body is not coaxially arranged with the cylindrical base such that a longitudinal axis of the elongated body is parallel to the axis of the cylindrical base but in a certain distance to it.

Then, the first locking element such as for example the hook-like protrusion is arranged at the elongated body such that it is positioned within a range of the axis of the cylindrical base. In other words, the axis of the cylindrical base, which is about identical with the longitudinal axis of the connector runs through the first locking element or rather through the locking area of it. In this way, the forces within the connector resulting from the clamping of the PCBs act in the direction of the longitudinal axis of the connector which forces can therefore be best used to achieve a strong clamping.

The first locking element may however also be arranged at the elongated body eccentrically to the axis of the cylindrical base or the longitudinal axis of the connector respectively. Since the forces in such an implementation do not act in the direction of the longitudinal axis but in a certain angle thereto, the clamping might be less strong.

In order to remove the connector once it is installed to connect two PCBs, the only thing to do is to disengage the two locking elements. Since these two locking elements are positively locked, the force to disengage them shall not be applied in the direction of the longitudinal axis of the connector. Rather, a force perpendicular to it is to be used and particularly in a direction to pull the two locking members apart. Whereas during installation of the connector the first locking element moves towards the second locking element as soon as its locking area is slightly lower than the locking area of the second locking element, the first locking element has to be moved into the opposite direction, i. e. away from the second locking element, to release the connector from the positive locking with the second PCB. Once the two locking elements are unlatched, the connector may easily be removed by pulling it up through the opening in the first PCB.

Such a disengaging of the two locking members can for example be done using some kind of tool to actually pull the first locking member away from the second locking member. This could also be done manually. This might however be a bit tricky or fiddly since the connector itself is rather small in the range of some millimetres to some centimetres and it is accordingly difficult to correctly grasp the lower part of it and apply enough force to distance it from the second locking element. Another possibility would be to insert some kind of tool between the two locking members or between the locking portion and the second PCB and to push them apart. Again, this might be a bit tricky or fiddly. And in both cases there is the risk of damaging one or both of the PCBs while applying the force to separate the connector from the second PCB.

In another preferred embodiment of the invention, the head portion therefore has an opening for reception of a tool for removing the connector. The opening is arranged in parallel with the longitudinal axis of the connector and such that it may be accessed from above, i.e. from the up facing surface of the first PCB. The tool might be a screwdriver or another tool with a longitudinal but narrow tip that may be inserted into that opening. Once inserted, all there remains to do is to tip over the tool a little bit such that the locking members are separated. Due to the relatively long lever provided by the tool a minimum amount of force has to be applied and since the tool is safely hold within the opening there is absolutely no risk to damage anything.

The opening in the head portion may be a blind hole. But in an even more preferred embodiment of the invention, the opening is a through hole extending right through the whole head portion. In this embodiment, the tool may be inserted even deeper into the through hole such that the lever to distance the locking portion of the connector from the second PCB becomes even longer resulting in an even more reduced force necessary to separate the connector.

In the example where the elongated body of the locking portion is arranged off centred to the longitudinal axis of the connector and the first locking element such that it is positioned within a range of the axis of the cylindrical base, the tool may be inserted and lead through the opening of the head portion, and further down along the elongated body of the locking portion until the tip of the tool reaches the first locking member which extends in the centre of the connector. In this case, the locking member additionally forms a stopper for the tool to prevent that the tool is inserted too far thereby again reducing the risk of damage.

In another preferred embodiment of the invention, the connector includes an anti-twist protection element for interacting with a suitable anti-twist protection element of the first printed circuit board to protect the connector from rotation when connecting the first printed circuit board to the second printed circuit board by means of the connector.

This anti-twist protection element not only ensures that the connector is properly aligned when it is inserted into the opening of the first PCB but it also protects the connector from unwanted rotation when mounted.

The anti-twist protection element of the connector includes preferably a protrusion at the head portion and the anti-twist protection element of the first printed circuit board includes a suitable cutout within the first printed circuit board where suitable means suitable in size, shape and position. The anti-twist protection elements could also be a recess or the like of the connector and a suitable protrusion of the first printed circuit board.

The printed circuit board assembly according to the invention includes a first PCB, a second PCB arranged perpendicular to the first PCB and a connector as described above properly installed to mechanically fix the two PCBs to each other. Accordingly, the first PCB includes an opening and the second PCB includes a second locking element such that the first and the second PCB are fixed to each other in that the connector is inserted with its locking portion through the opening of the first PCB, retained on the first PCB by its head portion and in that the connector is positive locked to the second printed circuit board by means of the first locking element of the connector properly interacting with the second locking element of the second PCB.

In a preferred embodiment of the PCBA the first and the second PCB - in addition to the mechanical connection provided by the connector - are electrically connected to each other by means of at least one electrical pin-and-socket connector. Such pin-and-socket connectors are also designated as plug-and-socket connectors and include a male connector attached to one of the PCBs and a matching female connector attached to the other PCB where the male and the female connectors are put together to establish the required electrical connections between the PCBs.

Instead of or in addition to a pin-and-socket connection the PCBs may also be electrically connected by other kinds of electrical connectors such as for example terminal blocks, crimp connectors or even single wire cables soldered or otherwise connected to the appropriate terminals on the PCBs or even a ribbon cable with corresponding connectors on each PCB.

The method for connecting a first printed circuit board to a second printed circuit board according to the invention includes the following steps:
a) arranging the second printed circuit board perpendicular to the first printed circuit board,
b) aligning the first and the second printed circuit board in a mounting position,
c) inserting a connector as described above with its locking portion through an opening of the first printed circuit board,
d) retaining the connector with its head portion on the first printed circuit board and
e) fixing the first printed circuit board to the second printed circuit board by positive locking the first locking element of the connector with a second locking element of the second printed circuit board.

The method according to the invention for disconnecting or releasing a first PCB from a second PCB where the PCBs are connected to each other by means of a connector as described above, includes the following steps:
a) inserting a tip of a tool into an opening of the head portion of the connector,
b) tipping the tool with its tip remaining within the opening of the head portion such as to unlock the first locking element of the connector from the second locking element of the second printed circuit board,
c) removing the first printed circuit board from the second printed circuit board and
d) optionally removing the connector from the first printed circuit board by pulling it out of the opening of the first printed circuit board.

Other advantageous embodiments and combinations of features come out from the detailed description below and the totality of the claims.

### Brief description of the drawings

The drawings used to explain the embodiments show:
- Fig. 1: a schematic representation of a connector according to the invention in a side view,
- Fig. 2: the connector shown in fig. 1 in a bottom view,
- Fig. 3: a schematic representation of two perpendicularly arranged PCBs,
- Fig. 4: the PCBs shown in fig. 3 connected by the connector shown in fig. 1,
- Fig. 5a: a schematic representation of the cutouts of a first PCB to be connected by a connector according to the invention to a second PCB,
- Fig. 5b: a schematic representation of another embodiment of the cutouts of a first PCB,
- Fig. 6: a schematic representation of the cutouts of a second PCB to be connected by a connector according to the invention to a first PCB,
- Fig. 7: a schematic representation of a second embodiment of a connector according to the invention in a front view,
- Fig. 8: the connector shown in fig. 7 in a side view connecting a horizontal PCB to a vertical PCB,
- Fig. 9: a schematic representation of the cutouts of the vertical PCB of fig. 8,
- Fig. 10: a schematic representation of a third embodiment of a connector according to the invention,
- Fig. 11: a schematic representation of a fourth embodiment of a connector according to the invention,
- Fig. 12: a schematic representation of a fifth embodiment of a connector according to the invention,
- Fig. 13: a schematic representation of a sixth embodiment of a connector according to the invention,
- Fig. 14: a schematic representation of a PCB assembly to be connected by connectors according to the invention in a front view,
- Fig. 15: the PCB assembly shown in fig. 14 in an assembled state and connected by several connectors according to the invention,
- Fig. 16: a side view of a portion of the PCB assembly shown in fig. 15 in a side view,
- Fig. 17: a schematic representation of two PCBs connected by a connector according to the invention before disconnecting them by use of a tool and
- Fig. 18: the two PCBs shown in fig. 17 during disconnection.

In the figures, the same components are given the same reference symbols.

### Preferred embodiments

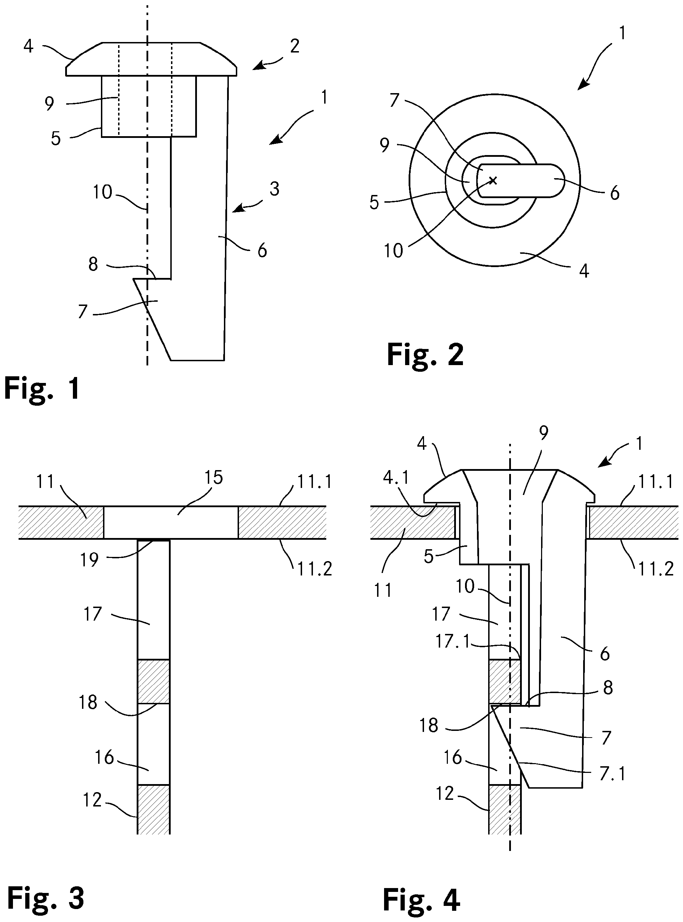

Fig. 1 and 2 show a schematic representation of a connector 1 according to the invention. Fig. 1 shows the connector in a side view and fig. 2 shows the connector in a bottom view. The connector 1 includes a head portion 2 and a locking portion 3. The head portion 2 includes a flange 4 and a base 5. The locking portion 3 includes an elongated body in the form of a shaft 6 and a hook 7 arranged at a lower end of the shaft 6 with a locking element. The locking element in this case is a generally flat locking area 8 facing the lower side of the flange 4.

The head portion 2 includes a through hole 9 which is shown in fig. 1 in dashed lines. An longitudinal axis 10 of the connector 1 is shown to run through about the centre of the connector 1 thereby traversing the through hole 9, running along the shaft 6 and traversing the locking area 8 of the hook 7.

Fig. 3 and 4 show a cross-sectional view of two PCBs where a first PCB 11 is arranged horizontally and a second PCB 12 is arranged vertically with its upper edge being in contact with the lower surface 11.2 of the horizontal PCB 11. Fig. 3 shows the two PCBs 11, 12 arranged to be fixed to each other and fig. 4 shows the two PCBs mechanically fixed to each other by a connector 2. In fig. 4 the connector 2 is also shown in a cross-sectional view.

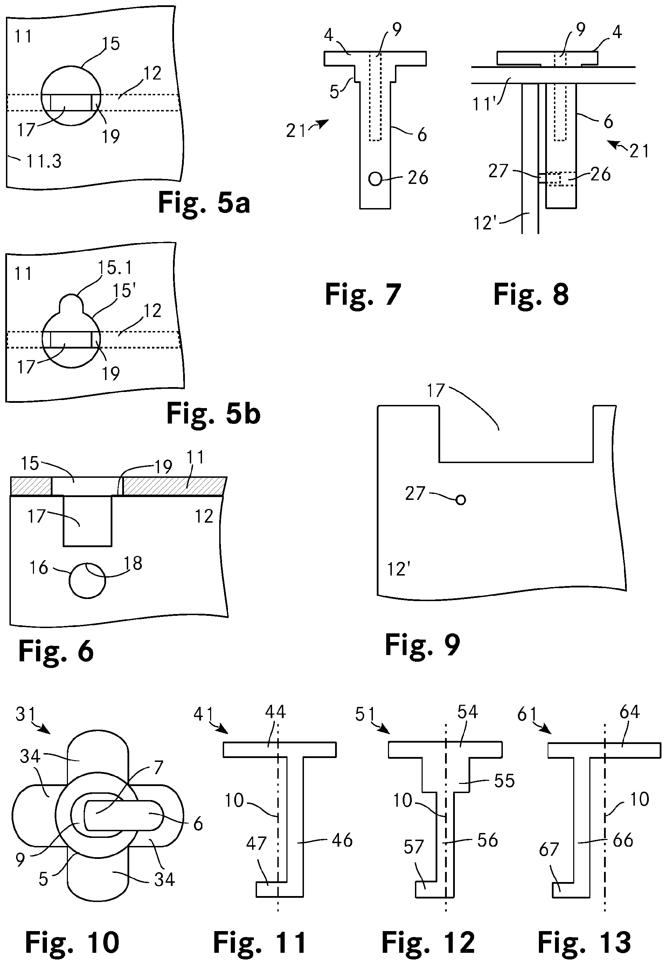

The first PCB 11 includes a cutout in the form of a hole 15 and the second PCB 12 includes two cutouts 16, 17. The first cutout 16 includes an upper inner locking element that serves as a down facing locking area 18 for interacting with the up facing locking area 8 of the connector 1 as explained in connection with fig. 4. The cutout 16 is large enough to at least partially receive the hook 7 of a connector 2 that is used to mechanically fix the two PCBs 11, 12 to each other. The upper cutout 17 is present to allow a connector to be inserted through the hole 15 until the flange 4 of the connector touches the upper surface 11.1 thereby being retained on the first PCB 11 and preventing the connector 1 from being inserted too far. The shape of the cutouts of the PCBs 11, 12 is shown in fig. 5 and 6 and described further below.

For fixing the PCBs 11, 12 to each other, they are first properly arranged to each other. For this purpose, the PCBs 11, 12 may include any kind of positioning means as known in the art such as for example recesses and protrusions, some kind of jig for alignment of the PCBs, corresponding male/female electrical connectors and the like. Then, the connector 1 is inserted into the hole 15 until the base 5 fits into the hole 15 and the flange 4 rests on the upper surface 11.1 of the PCB 11. While inserting the connector 1 into the hole 15, the slanted edge 7.1 of the hook 7 comes in contact with the lower boundary 17.1 of the upper cutout 17. When the connector 1 is further inserted, either the hook 7 is slightly pushed away from the axis 10 of the connector 1 due to the flexibility of the shaft 6 and the hook 7 and/or the hole connector 1 is slightly tilted such that the hook 7 passes the lower boundary 17.1 until the tip of the hook 7 latches into the lower cutout 16 such that the locking area 8 and the locking area 18 are facing and touching each other thereby preventing any relative movement of the connector 1 and the two PCBs 11, 12. In this way, the upper PCB 11 and the adjacent lower PCB 12 are clamped between the flange 4 and the hook 7 and more particular between the lower edge 4.1 of the flange 4 and the locking area 8.

Fig. 5a shows the detail of the upper PCB 11 including the hole 15 in a top view. Accordingly, the upper surface 11.1 of the PCB 11 is shown. In this embodiment, the hole 15 is a circular hole that has a diameter that corresponds to the diameter of the circular base 5 of the connector 1. In fact, the diameter of the hole 15 might be somewhat larger than that of the base 5 such that the connector 1 with its base 5 can fit smoothly into the hole 15. In this case, the hole 15 is arranged in the vicinity of an edge 11.3 of the PCB 11. The lower PCB 12 is arranged perpendicular to the upper PCB 11 such that generally only its upper edge 19 is visible. But since it is arranged below the upper PCB 11, only the small part of the upper edge 19 that is directly beneath the hole 15 is actually visible through the hole 15. And that part of the PCB 12 just includes the upper cutout 17 as more clearly shown in fig. 6. Fig. 6 shows the lower PCB 12 in a side view. The PCB 12 further includes the lower cutout 16 with its down facing locking area 18.

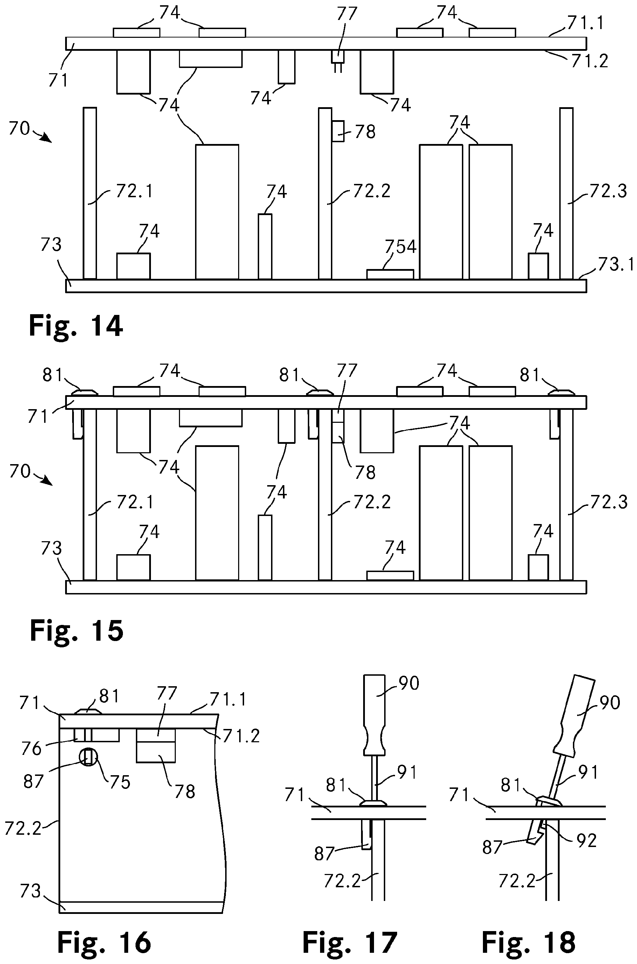

Fig. 5b is almost identical to fig. 5a with one single exception. Fig. 5b shows another example of a hole 15' in the upper PCB 11. In this example, the hole 15' basically is still a circular hole but it includes an additional, generally half-circular cutout 15.1 at the edge of the circular hole. This additional cutout 15.1 gives room for the tool to be tilted when the tool is inserted into the opening of the connector to release the upper PCB 11 from the lower PCB 12 as explained later in connection with fig. 18. The cutout 15.1 can also be used to realise an anti-twist protection or safeguard. For example by providing the shaft of the connector with a particular shape such that the connector with its base fits through the hole 15' and such that the shaft at least partially fits into or through the cutout 15.1. In this way, the connector has to be properly aligned for insertion and is protected against unwanted rotation within the hole 15'.

And fig. 6 also shows the upper PCB 11 and in particular a cross-sectional view of the upper PCB 11 where the lower PCB 12 is in touch with the upper PCB 11. Accordingly, the hole 15 is located right above the upper cutout 17.

Fig. 7 and 8 show a second embodiment of a connector 21 according to the invention. Fig. 7 shows the connector 21 in a front view and fig. 8 shows the connector 21 in a side view. Fig. 8 further shows an upper PCB 11' and a lower PCB 12' fixed to each other by the connector 21. In this example, only the outline of the connector 21 is shown and in addition the hole 9 within the connector 21 in dashed lines which here is a blind hole.

The connector 21 includes a flange 4, a base 5 and a shaft 6 but instead of a hook it includes a recess 26, here in the form of a hole. Accordingly, the locking element on the lower PCB 12' is not a recess or the like but it is a pin 27 extending from the lower PCB 12' for latching into the recess 26 when the connector 21 is installed and inserted into the opening in the upper PCB 11'.

Fig. 9 schematically shows the lower PCB 12' in a front view including the pin 27 extending from the surface of the PCB 12' and including the upper cutout 17 which in this case is considerably wider than the cutout 17 as shown in fig. 6. This wide cutout 17 for example creates the space for an electrical connector arranged on the upper PCB 11'.

Fig. 10 schematically shows a third embodiment of a connector 31 in a bottom view that largely corresponds to the connector 2 shown in fig. 2. It also includes a base 5 with a through hole 9 and a shaft 6 with a hook 7 at its lower end. However, the connector 31 does not include a circular flange but it includes four flange wings 34 in a circular arrangement and each of them affixed to the base 5. In this way less material is necessary to build the connector 31.

Instead of 4 flange wings 34, the flange portion of a connector according to the invention might also include just three or two such flange wings or it might also include more than four such flange wings. Then the size and shape of the flange wings may also be different. They can be longer or shorter or they can be wider or narrower or they can have a completely different shape. They just have to extend over the base such as to hold the connector at the upper PCB.

Fig. 11 to 13 schematically show further embodiments of a connector 41, 51, 61 according to the invention where again only the outline of the connectors 41, 51, 61 is shown. In all three examples the longitudinal axis 10 of the connector 41, 51, 61 is also shown which runs about through the centre of the flange 44, 54, 64.

Fig. 11 schematically shows a fourth embodiment of a connector 41. The connector 41 includes a head portion with a flange 44 and a locking portion with a shaft 46 and a hook-like protrusion 47 at the lower end of the shaft 46. The connector 41 does not include a base. In this embodiment, the shaft 46 is arranged excentrically in relation to the axis 10 of the connector 41. And the hook-like protrusion 47 is arranged at the lower end of the shaft 46 such that the hook-like protrusion 47 points towards the axis 10 of the connector 41. The axis 10 therefore runs through the hook-lil<e protrusion 47.

Fig. 12 schematically shows a fifth embodiment of a connector 51. The connector 51 includes a head portion with a flange 54 and a base 55 as well as a locking portion with a shaft 56 and a hook-like protrusion 57 at the lower end of the shaft 56. In this embodiment, the shaft 56 is arranged about centrically in relation to the axis 10 of the connector 51. And the hook-like protrusion 57 is arranged at the lower end of the shaft 56 such that it extends outwardly from the shaft 56 as well outwardly from the axis 10. The axis 10 therefore runs through the hook-like protrusion 57.

Fig. 13 schematically shows a sixth embodiment of a connector 61. The connector 61 includes a head portion with a flange 64 and a locking portion with a shaft 66 and a hook-like protrusion 67 at the lower end of the shaft 66. The connector 61 does not include a base. In this embodiment, the shaft 66 is arranged eccentrically in relation to the axis 10 of the connector 61. Contrary to the hook-like protrusion 47 of connector 41 shown in fig. 11, the hook-like protrusion 67 in this example is arranged at the lower end of the shaft 66 such that it points away from the axis 10 of the connector 61. The axis 10 therefore does not run through the hook-like protrusion 67.

Not shown in the embodiments of fig. 11 -13 is the opening within the head portion for reception of a tool to remove the connector once it is installed. Further, it is to note that these embodiments of the invention do not incorporate an anti-twist protection or safeguard.

Fig. 14 and 15 show a PCB assembly 70 including a top PCB 71, a bottom PCB 73 and three middle PCBs 72.1, 72.2, 72.3 which are mechanically fixed to the bottom PCB 73 in a front view. These middle PCBs 72.1, 72.2, 72.3 are fixed to the bottom PCB 73 by any suitable means such as screws, glue, press fit or any other suitable technology to mechanically fix two perpendicularly arranged PCBs - either to be easily removed again or permanently fixed to each other. The middle PCBs 72.1, 72.2, 72.3 can even be fixed to the bottom PCB 73 each by means of connectors according to the invention (not shown). It is to mention that the middle PCBs 72.1, 72.2, 72.3 and the bottom PCB 73 may also be electrically connected to each other by suitable electrical connections as required by the particular application.

The top PCB 71 is populated with a plurality of electrical components 74 provided on its upper surface 71.1 as well as its lower surface 71.2. And also the bottom PCB 73 is populated with a plurality of electrical components 74, in this example however just on the upper surface 73.1 to which also the middle PCBs 72.1, 72.2, 72.3 are attached. The top PCB 71 further includes a male plug 77 on its lower surface 71.2 the pins of which are arranged to be inserted into corresponding sockets of a female plug 78 arranged on the middle PCB 72.2 for establishing electrical connections between the top PCB 71 and the middle PCBs 72.1, 72.2, 72.3 as well as the bottom PCB 73 as required.

Whereas such an electrical plug and socket connection is only shown for one middle PCB 72.2 it is to be understood that any of the middle PCBs 72.1, 72.2, 72.3 may include such a female plug that corresponds with a male plug of the top PCB 71. And it is further to be understood that the male plug may also be arranged on the middle PCBs 72.1, 72.2, 72.3 and the female plugs on the top PCB 71 or they may be mixed. And it is clear that the electrical connections between the top PCB 71 and the middle PCBs 72.1, 72.2, 72.3 may also be established by any other suitable means or that there are no electrical connections between these PCBs at all.

In order to mechanically fix the top PCB 71 to the middle PCBs 72.1, 72.2, 72.3 the top PCB now is to be connected to each of the middle PCBs 72.1, 72.2, 72.3 by a connector 81 according to the invention.

Fig. 14 shows the PCB assembly 70 before it is assembled with the preassembled bottom PCB 73 and the middle PCBs 72.1, 72.2, 72.3. And fig. 15 shows the PCB assembly 70 completely assembled.

In a first step, the top PCB 71 is properly positioned above the preassembled bottom PCB 73 and middle PCBs 72.1, 72.2, 72.3. as shown in fig. 14 and then they are jointed such that the upper edges of the middle PCBs 72.1, 72.2, 72.3. come in touch with the lower surface 71.2 of the top PCB 71 and such that the pins of the male plug 77 are inserted into the corresponding sockets of the female plug 78. Once fitted together, a connector 81 according to the invention is inserted into corresponding cutouts (not shown in fig. 14, 15) in the top PCB 71 such that the hook-like protrusions at the lower end of the connectors 81 latch into corresponding cutouts (not shown in fig. 14, 15) of the middle PCBs 72.1, 72.2, 72.3. In this way, the top PCB 71 is mechanically fixed to each of the middle PCBs 72.1, 72.2, 72.3 as described above. It is to be understood that not necessarily all of the middle PCBs 72.1, 72.2, 72.3 have to be fixed to the top PCB 71 by means of a connector and it is also possible that two or more connectors are used to mechanically fix the top PCB 71 to a single middle PCB 72.1, 72.2, 72.3.

Fig. 16 shows the middle PCB 72.2 fixed to the bottom PCB 73 and to the top PCB 71 by the connector 81 in a side view. The male plug 77 that is arranged at the lower surface 71.2 of the top PCB 71 is inserted into the female plug to establish electrical connections.

The connector 81 is installed such that its flange rests on the upper surface 71.1 of the top PCB 71 and that its hook 87 is latched into the cutout 75 of the middle PCB 72.2. Also shown in fig. 16 is the upper cutout 76 within the middle PCB 72.2 wherefore a part of the shaft of the connector 81 is visible through the cutout 76.

Fig. 17 and 18 show a more detailed view of a part of the PCB assembly 70 of fig. 14 and 15. In particular they show the removal of the connector 81 from the top PCB 71 and the middle PCB 72.2 which are fixed to each other by the connector 81. Fig. 17 shows the first step where the tip 91 of a tool 90 is inserted into the hole within the connector 81. The tip 91 thereby reaches beneath the top PCB 71 either down to the hook 87 or somewhere between the lower surface of the top PCB 71 and the hook 87.

The tool 90 may for example be a screwdriver, an awl or the like with a long narrow tip 91 small enough such that the tip may be inserted into the opening within the connector 81.

Fig. 18 shows the next step to remove the connector 81. After insertion of the tip 91 of the tool 90 into the opening of the connector 81 the tool 90 has just to be tilted slightly such that its tip 91 pushes the shaft of the connector 81 away from the middle PCB 72.2. In order to better allow the tool to be tilted in this direction, the opening in the top PCB 71 might have the shape as shown in fig. 5b such that the shaft of the connector 81 can move into the additional cutout 15.1 when the tool is tilted.

In this way, the hook 87 is released from the cutout 75 and can then be removed easily by either pulling it out of the opening of the top PCB 71 or by pulling apart the top PCB 71 and the middle PCB 72.2.

In summary, it is to be noted that the invention enables to removably fix two perpendicularly arranged printed circuit boards to each other by means of a connector that can easily be removed once the two PCBs shall be released.

## Claims

1. Printed board assembly (70) including a first printed circuit board (11, 71), a second printed circuit board (12, 72) arranged perpendicular to the first printed circuit board (11, 71) and a connector (1, 21, 31, 41, 51, 61, 81) for removably connecting the first printed circuit board (11, 71) to the second printed circuit board (12, 72),
the connector (1, 21, 31, 41, 51, 61, 81) having a locking portion (3) for inserting through an opening of the first printed circuit board (11, 71) and a head portion (2) for retaining the connector (1, 21, 31, 41, 51, 61, 81) on the first printed circuit board (11, 71),
wherein the locking portion (3) includes a first locking element adapted to interact with a second locking element of the second printed circuit board (12, 72) for positive locking the connector (1, 21, 31, 41, 51, 61, 81) and the second printed circuit board (12, 72) regarding forces in a direction perpendicular to the first printed circuit board (11, 71) such that the first printed circuit board (11, 71) is fixed to the second printed circuit board (12, 72) when the connector (1, 21, 31, 41, 51, 61, 81) is inserted through the opening of the first printed circuit board (11, 71) and the first and the second locking element are positive locked to each other,
wherein the first printed circuit board (11,71) includes the opening, the second printed circuit board (12, 72) includes the second locking element, wherein the first and the second printed circuit board (12, 72) are fixed to each other in that the connector (1, 21, 31, 41, 51, 61, 81) is inserted with its locking portion (3) through the opening and retained by its head portion (2) on the first printed circuit board (11, 71) and in that the connector (1,21,31,41,51,61,81) is positive locked to the second printed circuit board (12, 72) by means of the first and second locking element,
wherein the head portion (2) has a base (5, 55) for fitting through the opening of the first printed circuit board (11, 71) and a retaining section for retaining the connector (1, 21, 31, 41, 51, 61, 81) on the first printed circuit board (11, 71),
wherein the base (5, 55) is generally cylindrical and wherein the head portion (2) includes a flange like edge (4.1, 7.1, 11.3, 19) extending at least partially over the cylindrical base (5, 55),
wherein the locking portion (3) includes an elongated body and where the first locking element includes a hook-like protrusion (7, 87) at an end region of the elongated body opposite the head portion (2) for latching into an opening or recess (26) of the second printed circuit board (12, 72),
wherein the first locking element is a generally flat locking area (8, 18) facing the lower side of the flange like edge (4.1, 7.1, 11.3, 19).

2. Printed board assembly (70) according to claim 1, wherein the first printed circuit board (11, 71) and the second printed circuit board (12, 72) are electrically connected to each other by means of at least one electrical pin-and-socket connector (1, 21, 31, 41, 51, 61, 81).

3. Printed board assembly (70) according to any of the preceding claims, wherein the head portion (2) is arranged at an end region of the connector (1, 21, 31, 41, 51, 61, 81) and the locking portion (3) is arranged at another end region of the connector (1, 21, 31, 41, 51, 61, 81) opposite the head portion (2).

4. Printed board assembly (70) according to any of the preceding claims, wherein the first locking element includes a locking area (8, 18) arranged to face the flange like edge (4.1, 7.1, 11.3, 19) of the head portion (2).

5. Printed board assembly (70) according to any of the preceding claims, wherein the locking portion (3) is arranged at an edge area of the cylindrical base (5, 55) such that a longitudinal axis of the elongated body is arranged in parallel to an axis (10) of the cylindrical base (5, 55) and that the elongated body is arranged in a distance with the axis (10) of the cylindrical base (5, 55).

6. Printed board assembly (70) according to claim 5, wherein the first locking element is arranged at the elongated body such that it is positioned within a range of the axis (10) of the cylindrical base (5, 55).

7. Printed board assembly (70) according to any of the preceding claims, wherein the head portion (2) has an opening for reception of a tool (90) for removing the connector (1, 21, 31, 41, 51, 61, 81).

8. Printed board assembly (70) according to claim 7, wherein the opening in the head portion (2) is a through hole (9).

9. Printed board assembly (70) according to any of the preceding claims, including an anti-twist protection element for interacting with a suitable anti-twist protection element of the first printed circuit board (11, 71) to protect the connector (1, 21, 31, 41, 51, 61, 81) from rotation when connecting the first printed circuit board (11, 71) to the second printed circuit board (12, 72) by means of the connector (1, 21, 31, 41, 51, 61, 81), wherein the anti-twist protection element of the connector (1, 21, 31, 41, 51, 61, 81) preferably includes a protrusion at the head portion (2) to fit an anti-twist protection cutout (16, 17) within the first printed circuit board (11, 71).

10. Method for connecting a first printed circuit board (11, 71) of a printed board assembly (70) according to any of the preceding claims to a second printed circuit board (12, 72) of said printed board assembly (70), including the steps of
a) arranging the second printed circuit board (12, 72) perpendicular to the first printed circuit board (11, 71),
b) aligning the first and the second printed circuit board (12, 72) in a mounting position
c) inserting the connector (1, 21, 31, 41, 51, 61, 81) of said printed board assembly with its locking portion (3) through ar opening of the first printed circuit board (11, 71),
d) retaining the connector (1, 21, 31, 41, 51, 61, 81) with its head portion (2) on the first printed circuit board (11, 71) and
e) fixing the first printed circuit board (11, 71) to the second printed circuit board (12, 72) by positive locking the first locking element of the connector (1, 21, 31, 41, 51, 61, 81) with a second locking element of the second printed circuit board (12, 72).

11. Method for disconnecting a first printed circuit board (11, 71) of a printed board assembly (70) according to any of the preceding claims from a second printed circuit board (12, 72) of said printed board assembly (70) where the first and the second printed circuit board are connected to each other according to the method of claim 10 by means of the connector (1, 21, 31, 41, 51, 61, 81) of said printed board assembly (70), including the steps of
a) inserting a tip of a tool (90) into an opening of the head portion (2) of the connector (1, 21, 31, 41, 51, 61, 81),
b) tipping the tool (90) with its tip remaining within the opening of the head portion (2) such as to unlock the first locking element of the connector (1, 21, 31, 41, 51, 61, 81) from the second locking element of the second printed circuit board (12, 72),
c) removing the first printed circuit board (11, 71) from the second printed circuit board (12, 72) and
d) optionally removing the connector (1, 21, 31, 41, 51, 61, 81) from the first printed circuit board (11, 71) by pulling it out of the opening of the first printed circuit board (11, 71).

## Patentansprüche

1. Leiterplattenanordnung (70) mit einer ersten Leiterplatte (11, 71), einer zweiten Leiterplatte (12, 72), die senkrecht zu der ersten Leiterplatte (11, 71) angeordnet ist, und einem Verbinder (1, 21, 31, 41, 51, 61, 81) zum lösbaren Verbinden der ersten Leiterplatte (11, 71) mit der zweiten Leiterplatte (12, 72),
wobei der Verbinder (1,21,31,41,51,61,81) einen Verriegelungsteil (3) zum Einführen durch eine Öffnung der ersten Leiterplatte (11, 71) und einen Kopfteil (2) zum Halten des Verbinders (1, 21, 31, 41, 51, 61, 81) auf der ersten Leiterplatte (11, 71) aufweist,
wobei der Verriegelungsteil (3) ein erstes Verriegelungselement enthält, das so beschaffen ist, dass es mit einem zweiten Verriegelungselement der zweiten Leiterplatte (12, 72) zusammenwirkt, um den Verbinder (1,21,31,41,51,61,81) und die zweite Leiterplatte (12, 72) in Bezug auf Kräfte in einer Richtung senkrecht zu der ersten Leiterplatte (11, 71) formschlüssig miteinander zu verbinden, so dass die erste Leiterplatte (11, 71) an der zweiten Leiterplatte (12, 72) befestigt ist, wenn der Verbinder (1, 21, 31, 41, 51, 61, 81) durch die Öffnung der ersten Leiterplatte (11, 71) eingeführt wird und das erste und das zweite Verriegelungselement formschlüssig miteinander verbunden sind,
wobei die erste Leiterplatte (11, 71) die Öffnung aufweist, die zweite Leiterplatte (12, 72) das zweite Verriegelungselement aufweist, wobei die erste und die zweite Leiterplatte (12, 72) dadurch aneinander befestigt sind, dass der Verbinder (1,21,31,41,51,61,81) mit seinem Verriegelungsteil (3) durch die Öffnung eingeführt und durch seinen Kopfteil (2) auf der ersten Leiterplatte (11, 71) gehalten wird und dass der Verbinder (1, 21, 31, 41, 51, 61, 81) mittels des ersten und zweiten Verriegelungselements formschlüssig an der zweiten Leiterplatte (12, 72) verriegelt wird,
wobei der Kopfteil (2) eine Basis (5, 55) zum Einpassen durch die Öffnung der ersten Leiterplatte (11, 71) und einen Halteabschnitt zum Halten des Verbinders (1, 21, 31, 41, 51, 61, 81) auf der ersten Leiterplatte (11, 71) aufweist,
wobei die Basis (5, 55) allgemein zylindrisch ist und wobei der Kopfteil (2) einen flanschartigen Rand (4.1, 7.1, 11.3, 19) aufweist, der sich zumindest teilweise über die zylindrische Basis (5, 55) erstreckt,
wobei der Verriegelungsteil (3) einen langgestreckten Körper aufweist und wobei das erste Verriegelungselement einen hakenartigen Vorsprung (7, 87) an einem Endbereich des langgestreckten Körpers gegenüber dem Kopfteil (2) zum Einrasten in eine Öffnung oder Aussparung (26) der zweiten Leiterplatte (12, 72) aufweist,
wobei das erste Verriegelungselement ein allgemein flacher Verriegelungsbereich (8, 18) ist, der der unteren Seite des flanschartigen Rands (4.1, 7.1, 11.3, 19) gegenüberliegt.

2. Leiterplattenanordnung (70) nach Anspruch 1, wobei die erste Leiterplatte (11, 71) und die zweite Leiterplatte (12, 72) mittels mindestens eines elektrischen Steckverbinders (1, 21, 31, 41, 51, 61, 81) elektrisch miteinander verbunden sind.

3. Leiterplattenanordnung (70) nach einem der vorhergehenden Ansprüche, wobei der Kopfteil (2) an einem Endbereich des Verbinders (1, 21, 31, 41, 51, 61, 81) angeordnet ist und der Verriegelungsteil (3) an einem anderen Endbereich des Verbinders (1,21,31,41,51,61,81) gegenüber dem Kopfteil (2) angeordnet ist.

4. Leiterplattenanordnung (70) nach einem der vorhergehenden Ansprüche, wobei das erste Verriegelungselement einen Verriegelungsbereich (8, 18) aufweist, der so angeordnet ist, dass er dem flanschartigen Rand (4.1, 7.1, 11.3, 19) des Kopfteils (2) gegenüberliegt.

5. Leiterplattenanordnung (70) nach einem der vorhergehenden Ansprüche, wobei der Verriegelungsteil (3) an einem Randbereich der zylindrischen Basis (5, 55) so angeordnet ist, dass eine Längsachse des langgestreckten Körpers parallel zu einer Achse (10) der zylindrischen Basis (5, 55) angeordnet ist und dass der langgestreckte Körper in einem Abstand zur Achse (10) der zylindrischen Basis (5, 55) angeordnet ist.

6. Leiterplattenanordnung (70) nach Anspruch 5, wobei das erste Verriegelungselement so an dem langgestreckten Körper angeordnet ist, dass es in einem Bereich der Achse (10) des zylindrischen Grundkörpers (5, 55) positioniert ist.

7. Leiterplattenanordnung (70) nach einem der vorhergehenden Ansprüche, wobei der Kopfteil (2) eine Öffnung zur Aufnahme eines Werkzeugs (90) zum Entfernen des Verbinders (1, 21, 31, 41, 51, 61, 81) aufweist.

8. Leiterplattenanordnung (70) nach Anspruch 7, wobei die Öffnung im Kopfteil (2) ein Durchgangsloch (9) ist.

9. Leiterplattenanordnung (70) nach einem der vorhergehenden Ansprüche, mit einem Verdrehschutzelement zum Zusammenwirken mit einem geeigneten Verdrehschutzelement der ersten Leiterplatte (11, 71), um den Verbinder (1, 21, 31, 41, 51, 61, 81) vor Drehung zu schützen, wenn die erste Leiterplatte (11, 71) mit der zweiten gedruckten Leiterplatte (12, 72) mittels des Verbinders (1, 21, 31, 41, 51, 61, 81) verbunden wird, wobei das Verdrehschutzelement des Verbinders (1, 21, 31, 41, 51, 61, 81) vorzugsweise einen Vorsprung an dem Kopfteil (2) aufweist, um in einen Verdrehschutzausschnitt (16, 17) innerhalb der ersten gedruckten Leiterplatte (11, 71) zu passen.

10. Verfahren zum Verbinden einer ersten Leiterplatte (11, 71) einer Leiterplattenanordnung (70) nach einem der vorhergehenden Ansprüche mit einer zweiten Leiterplatte (12, 72) der Leiterplattenanordnung (70), mit den Schritten
a) Anordnen der zweiten Leiterplatte (12, 72) senkrecht zur ersten Leiterplatte (11, 71),
b) Ausrichten der ersten und der zweiten Leiterplatte (12, 72) in einer Montageposition
c) Einführen des Verbinders (1, 21,31,41,51, 61,81) der besagten Leiterplattenanordnung mit seinem Verriegelungsteil (3) durch eine Öffnung der ersten Leiterplatte (11, 71),
d) Festhalten des Verbinders (1,21,31,41,51,61,81) mit seinem Kopfteil (2) auf der ersten Leiterplatte (11, 71) und
e) Befestigen der ersten Leiterplatte (11, 71) an der zweiten Leiterplatte (12, 72) durch formschlüssiges Verriegeln des ersten Verriegelungselements des Verbinders (1, 21, 31, 41,51,61,81) mit einem zweiten Verriegelungselement der zweiten Leiterplatte (12,72).

11. Verfahren zum Trennen einer ersten Leiterplatte (11, 71) einer Leiterplattenanordnung (70) nach einem der vorhergehenden Ansprüche von einer zweiten Leiterplatte (12, 72) der Leiterplattenanordnung (70), wobei die erste und die zweite Leiterplatte nach dem Verfahren des Anspruchs 10 mittels des Verbinders (1,21,31,41, 51,61,81) der Leiterplattenanordnung (70) miteinander verbunden sind, mit den Schritten
a) Einführen einer Spitze eines Werkzeugs (90) in eine Öffnung des Kopfteils (2) des Verbinders (1, 21, 31, 41, 51, 61, 81),
b) Kippen des Werkzeugs (90), wobei seine Spitze in der Öffnung des Kopfteils (2) verbleibt, um das erste Verriegelungselement des Verbinders (1, 21, 31, 41, 51, 61, 81) von dem zweiten Verriegelungselement der zweiten Leiterplatte (12, 72) zu entriegeln,
c) Entfernen der ersten Leiterplatte (11, 71) von der zweiten Leiterplatte (12, 72) und
d) optionales Entfernen des Verbinders (1,21,31,41,51,61,81) von der ersten Leiterplatte (11, 71), indem er aus der Öffnung der ersten Leiterplatte (11, 71) herausgezogen wird.

## Revendications

1. Ensemble de circuits imprimés (70) comprenant un premier circuit imprimé (11, 71), un deuxième circuit imprimé (12, 72) agencé perpendiculairement au premier circuit imprimé (11, 71), et un connecteur (1, 21, 31, 41, 51, 61, 81) destiné à connecter de manière amovible le premier circuit imprimé (11, 71) au deuxième circuit imprimé (12, 72),
le connecteur (1, 21, 31, 41, 51, 61, 81) comportant une portion de verrouillage (3) destinée à être insérée à travers une ouverture du premier circuit imprimé (11, 71) et une portion de tête (2) destinée à retenir le connecteur (1, 21, 31, 41, 51, 61, 81) sur le premier circuit imprimé (11, 71),
dans lequel la portion de verrouillage (3) comprend un premier élément de verrouillage adapté pour interagir avec un deuxième élément de verrouillage du deuxième circuit imprimé (12, 72) afin d'autoverrouiller le connecteur (1, 21, 31, 41, 51, 61, 81) et le deuxième circuit imprimé (12, 72) par rapport aux forces agissant dans une direction perpendiculaire au premier circuit imprimé (11, 71), de telle sorte que le premier circuit imprimé (11, 71) est fixé au deuxième circuit imprimé (12, 72) quand le connecteur (1, 21, 31, 41, 51, 61, 81) est inséré à travers l'ouverture du premier circuit imprimé (11, 71) et les premier et deuxième éléments de verrouillage sont autoverrouillés entre eux,
dans lequel le premier circuit imprimé (11, 71) comprend l'ouverture, le deuxième circuit imprimé (12, 72) comprend le deuxième élément de verrouillage, dans lequel les premier et deuxième circuits imprimés (12, 72) sont fixés l'un à l'autre, de telle sorte que le connecteur (1, 21, 31, 41, 51, 61, 81) est inséré avec sa portion de verrouillage (3) à travers l'ouverture et retenu par sa portion de tête (2) sur le premier circuit imprimé (11, 71) et que le connecteur (1, 21, 31, 41, 51, 61, 81) est autoverrouillé sur le deuxième circuit imprimé (12, 72) au moyen des premier et deuxième éléments de verrouillage,
dans lequel la portion de tête (2) comporte une base (5, 55) destinée à être insérée à travers l'ouverture du premier circuit imprimé (11, 71) et une section de retenue destinée à retenir le connecteur (1, 21, 31, 41, 51, 61, 81) sur le premier circuit imprimé (11, 71),
dans lequel la base (5, 55) est généralement cylindrique et dans lequel la portion de tête (2) comprend un bord en forme de bride (4.1, 7.1, 11.3, 19) qui s'étend au moins partiellement au-dessus de la base cylindrique (5, 55),
dans lequel la portion de verrouillage (3) comprend un corps allongé et dans lequel le premier élément de verrouillage comprend une protubérance en forme de crochet (7, 87) sur une région d'extrémité du corps allongé opposée à la portion de tête (2) destinée à s'enclencher dans une ouverture ou un renfoncement (26) du deuxième circuit imprimé (12, 72),
dans lequel le premier élément de verrouillage est une zone de verrouillage généralement plane (8, 18) qui fait face au côté inférieur du bord en forme de bride (4.1, 7.1, 11.3, 19).

2. Ensemble de circuits imprimés (70) selon la revendication 1, dans lequel le premier circuit imprimé (11, 71) et le deuxième circuit imprimé (12, 72) sont connectés électriquement entre eux au moyen d'au moins un connecteur électrique enfichable (1, 21, 31, 41, 51, 61, 81).

3. Ensemble de circuits imprimés (70) selon l'une quelconque des revendications précédentes, dans lequel la portion de tête (2) est agencée sur une région d'extrémité du connecteur (1, 21, 31, 41, 51, 61, 81) et la portion de verrouillage (3) est agencée sur une autre région d'extrémité du connecteur (1, 21, 31, 41, 51, 61, 81) opposée à la portion de tête (2).

4. Ensemble de circuits imprimés (70) selon l'une quelconque des revendications précédentes, dans lequel le premier élément de verrouillage comprend une zone de verrouillage (8, 18) agencée pour faire face au bord en forme de bride (4.1, 7.1, 11.3, 19) de la portion de tête (2).

5. Ensemble de circuits imprimés (70) selon l'une quelconque des revendications précédentes, dans lequel la portion de verrouillage (3) est agencée sur une zone de bord de la base cylindrique (5, 55), de telle sorte que l'axe longitudinal du corps allongé est agencé parallèlement à l'axe (10) de la base cylindrique (5, 55) et que le corps allongé est espacé de l'axe (10) de la base cylindrique (5, 55).

6. Ensemble de circuits imprimés (70) selon la revendication 5, dans lequel le premier élément de verrouillage est agencé sur le corps allongé de telle sorte qu'il est positionné à portée de l'axe (10) de la base cylindrique (5, 55).

7. Ensemble de circuits imprimés (70) selon l'une quelconque des revendications précédentes, dans lequel la portion de tête (2) comporte une ouverture destinée à recevoir un outil (90) pour enlever le connecteur (1, 21, 31, 41, 51, 61, 81).

8. Ensemble de circuits imprimés (70) selon la revendication 7, dans lequel l'ouverture dans la portion de tête (2) est un trou traversant (9).

9. Ensemble de circuits imprimés (70) selon l'une quelconque des revendications précédentes, comprenant un élément de protection anti-torsion destiné à interagir avec un élément de protection anti-torsion approprié du premier circuit imprimé (11, 71) afin de protéger le connecteur (1, 21, 31, 41, 51, 61, 81) contre une rotation lors de la connexion du premier circuit imprimé (11, 71) au deuxième circuit imprimé (12, 72) au moyen du connecteur (1, 21, 31, 41, 51, 61, 81), dans lequel l'élément de protection anti-torsion du connecteur (1, 21, 31, 41, 51, 61, 81) comprend de préférence une protubérance sur la portion de tête (2) pour y adapter une découpe de protection anti-torsion (16, 17) dans le premier circuit imprimé (11, 71).

10. Procédé de connexion d'un premier circuit imprimé (11, 71) d'un ensemble de circuits imprimés (70) selon l'une quelconque des revendications précédentes à un deuxième circuit imprimé (12, 72) dudit ensemble de circuits imprimés (70), comprenant les étapes suivantes :
a) agencement du deuxième circuit imprimé (12, 72) perpendiculairement au premier circuit imprimé (11, 71),
b) alignement des premier et deuxième circuits imprimés (12, 72) dans une position de montage,
c) insertion du connecteur (1, 21, 31, 41, 51, 61, 81) dudit ensemble de circuits imprimés avec sa portion de verrouillage (3) traversant une ouverture du premier circuit imprimé (11, 71),
d) retenue du connecteur (1, 21, 31, 41, 51, 61, 81) avec sa portion de tête (2) sur le premier circuit imprimé (11, 71), et
e) fixation du premier circuit imprimé (11, 71) au deuxième circuit imprimé (12, 72) par autoverrouillage du premier élément de verrouillage du connecteur (1, 21, 31, 41, 51, 61, 81) avec un deuxième élément de verrouillage du deuxième circuit imprimé (12, 72).

11. Procédé de déconnexion d'un premier circuit imprimé (11, 71) d'un ensemble de circuits imprimés (70) selon l'une quelconque des revendications précédentes d'un deuxième circuit imprimé (12, 72) dudit ensemble de circuits imprimés (70), dans lequel les premier et deuxième circuits imprimés sont connectés entre eux selon le procédé de la revendication 10 au moyen du connecteur (1, 21, 31, 41, 51, 61, 81) dudit ensemble de circuits imprimés (70), comprenant les étapes suivantes :
a) insertion de la pointe d'un outil (90) dans une ouverture de la portion de tête (2) du connecteur (1, 21, 31, 41, 51, 61, 81),
b) basculement de l'outil (90) avec sa pointe restant dans l'ouverture de la portion de tête (2) de manière à déverrouiller le premier élément de verrouillage du connecteur (1, 21, 31, 41, 51, 61, 81) du deuxième élément de verrouillage du deuxième circuit imprimé (12, 72),
c) enlèvement du premier circuit imprimé (11, 71) du deuxième circuit imprimé (12, 72), et
d) facultativement, enlèvement du connecteur (1, 21, 31, 41, 51, 61, 81) du premier circuit imprimé (11, 71) en le tirant hors de l'ouverture du premier circuit imprimé (11, 71).
